# EUROPEAN PATENT APPLICATION

(11) **EP 1 422 849 A1**
(43) Date of publication of application: **26.05.2004**
(21) Application number: 02258077.3
(22) Date of filing: 25.11.2002
(51) Int. Cl.: H04H 1/00, H03J 7/02, H03L 7/12

(54) **Method of Scanning for Carrier signals modulated with digital data and transmitted by satellite**

(71) Applicant: Pace Micro Technology Plc, Saltaire, Shipley, BD18 3LF (GB)
(72) Inventor: Goodwin,Tom c/o Pace Micro Technology Plc, Saltaire, Shipley BD18 3LF (GB)
(74) Representative: Wood, Graham

(57) **Abstract**

The invention provides a method for the installation of a broadcast data receiver of the type used to receive and process data broadcast from a remote location. The method involves the tuning of a local oscillator to each of a range of predetermined frequencies in steps, attempting to identify the data carrier at each frequency and if a predefined symbol rate is achieved, attempts to acquire the data transport stream associated with the carrier.

## Description

The invention to which this application particularly, although not necessarily exclusively relates, is to the searching or scanning for the frequency of data carriers which can be received in a broadcast data transmission system.

Broadcast data transmission systems, in particular, satellite data transmission systems, include a broadcaster at a particular location, broadcasting data to a number of remote locations. The data is transmitted via satellite to a satellite antenna receiver provided at each of said remote locations. From the antenna, the received data is carried to a broadcast data receiver, typically provided in connection with, or integrally with, a television set. The broadcast data receiver processes the received data to generate video, audio and/or auxiliary data from which television programmes and/or other services and functions can be provided to the television set user.

The data is transmitted from the satellite to the satellite antenna on a number of frequencies, each frequency having a carrier which carries the data transport streams.

In order for the broadcast data receiver and satellite antenna to operate correctly then, at least at the time of installation of the apparatus, it is necessary for the broadcast data receiver and satellite antenna to search for and locate the various carriers and frequencies of the same. Once located, the same can be identified such that when data is received on particular carrier frequencies, the broadcast data receiver can identify the same and process the received data accordingly.

As the process for searching for digital carriers locations, is an important part of the installation of the apparatus, it is important that the same is undertaken correctly. Conventional methods, while they may be efficient, do take a considerable period of time so that the speed of the search dictates to a large extent the duration of the installation process and is therefore a key performance issue in terms of time required, cost of the installer, and so on.

The aim of the present invention is to provide an improved carrier search method which is robust, reliable, and easily repeatable, so as to allow the duration of the installation of the apparatus to be reduced without unduly affecting the reliability or effectiveness of the process.

In a first aspect of the invention there is provided a method of identifying and locating digital data carriers received via a satellite data transmission system, said method comprising the steps of tuning a local oscillator incorporated in data receiving apparatus at the receiving location across a band of frequencies known to be received by the apparatus and characterised in that the local oscillator is tuned across said band of frequencies in steps and, at each step, an analysis is made as to whether a data carrier is identifiably present with a predefined symbol rate and, if so, a demodulator in the data receiving apparatus attempts to acquire the data transport stream which is associated with the located carrier.

Typically the method utilises a symbol timing recovery loop operable in two modes, a first mode for the acquisition of the incoming symbol frequency and a tracking mode in which once the incoming symbol frequency is identified, the swept frequency is tracked as the timing error detector output is fed back into the loop.

Typically, the frequency sweep generator has three control parameters, the sweep rate, the lower sweep limit and upper sweep limit.

Typically, if in a particular step during the search, no carrier is indicated, then the search process moves to the next frequency step, and so on until the search has passed through the entire band of frequencies.

In a further aspect of the invention there is provided a method for installing data receiving apparatus in the form of a broadcast data receiver at a location remote from the location from which data is transmitted, said data transmitted at a range of known frequencies, and characterised in that said method comprises the steps of tuning a local oscillator provided in the data receiving apparatus to tune to each of the known frequencies, said tuning operation performed in steps, each step at a particular known frequency, and, at each step, an analysis is made at the data receiving apparatus as to whether a data carrier is identifiably present and, if so, whether a predefined data symbol rate is achieved and, if the predefined symbol rate is achieved at the identified carrier a demodulator in the data receiving apparatus attempts to acquire the transport stream of data which is associated with that carrier.

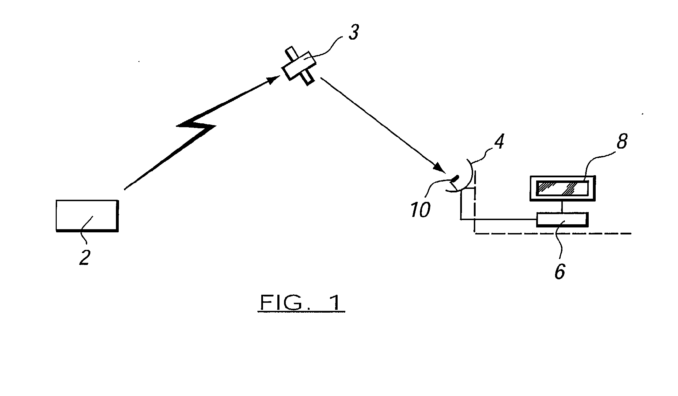

A specific embodiment of the invention is now described with reference to Figure 1 which illustrates a typical satellite broadcast data transmission system and the components thereof.

Figure 1 illustrates a satellite broadcast data transmission system in which there is provided a broadcaster 2 at a particular location, and from which data relating to a series of television programmes and programme channels is transmitted. The data is transmitted to a satellite 3 from which data is in turn passed on to be received by receiving apparatus at a number of locations remote from the broadcaster. At each location, there is provided a satellite antenna 4 and this is in turn connected to broadcast data receiver 6 in the premises. The broadcast data receiver is in turn connected to or provided integrally with television set 8. When transmitted to the satellite 3, the data is received over a band of frequencies and carried via data carriers at different frequencies to be received by a transponder 10 at the satellite antenna. The broadcast data receiver needs to be aware of the frequencies at which the carriers are transmitted so as to be able to receive and identify particular carriers and data thereon. The data is processed and decoded by the broadcast data receiver to allow identifiable television programmes to be selected to be viewed on a television set.

The essence of a fast scan and hence installation of the broadcast data receiver in accordance with the invention lies in the ability to quickly determine when a data carrier is not present at a particular frequency. This is a problem in conventional tuning methods, and is overcome by the present invention. The scan ring method must also be robust, in that it must be able to detect carriers with poor signal to noise ratios, in a reliable and repeatable manner.

The invention provides a method of scanning for digital data carriers on a satellite transponder in a rapid, reliable and robust manner. The scanning process involves tuning a local oscillator at the satellite receiving apparatus in steps across the known range or band of frequencies received by the receiver apparatus incorporating the satellite antenna 4 and broadcast data receiver 6. At each step, the method is invoked, in order to quickly determine whether a data carrier is present with a predetermined symbol rate. If clock lock is achieved, in that the timing loop in a demodulator in the data receiving apparatus locks to the symbol frequency of the digital data carrier, then the presence of the data carrier is identified and the demodulator is programmed to attempt acquisition of the data transport stream associated with the data carrier.

The method makes use of a specific hardware implementation that is controllable by software, and the hardware consists of a symbol timing recovery loop that operates in two modes, acquisition and tracking.

During the data acquisition mode, a sweep generator is applied to the recovery loop, such that a swept frequency offset is applied to the loop. When the swept frequency of the loop is sufficiently close to the incoming symbol frequency, the loop acquires a timing lock. The loop operates in the second mode and the sweep will then be tracked out by the loop, as a timing error detector output is fed back into the loop.

The sweep generator has 3 software controllable parameters, the sweep rate, the lower sweep limit, and the upper sweep limit. A further status register reports when the sweep limit is reached. The register is important in allowing the quick determination that a carrier signal is not present at the particular frequency.

The registers are controlled by the software as follows:
1. The clock lower sweep and upper sweep limits, are initially set with narrow offsets.
2. The sweep generator begins sweeping from the lower sweep limit, at a relatively slow sweep rate.
3. After a period that is sufficient for the loop to lock, the upper sweep limit is set to a wide offset, and the sweep is set to a fast rate.
4. The time taken for the clock sweep to reach the wide offset upper limit is calculated.
5. The status register is continuously polled to see if the upper sweep limit has been reached for a maximum duration of the calculated sweep time.
6. If a signal is not present, then the noise in the loop will cause the upper sweep limit to be exceeded. The software is able to immediately exit, and declare the loop not locked.
7. If the limit has not been reached, and the time to reach the upper sweep limit has expired, then the loop has locked.

The sweep rate is initially set to a slow rate so that the loop is able to lock to a signal with a poor signal to noise ratio. Specifically, the sweep rate is in one embodiment calibrated so as to lock to signals with a signal to noise ratio of as little as 2.5dB, at a carrier offset of as much as 2.5Mhz within the baseband filter, for a symbol rate range of 15-30MS/s. When the limits are set wide apart, they must be set sufficiently wide so that noise itself is within the locked loop does not cause the limits to be exceeded. However, they must also be set sufficiently close, so that if a signal is not present, the limits may quickly be exceeded, allowing the software to immediately declare that clock lock is not achieved. The noise in the loop plays an integral role in determining the speed of the method. The worse the signal to noise ratio the faster the software will declare that clock lock is not achieved. There is also a limit on the speed of the faster sweep rate, as the loop may not be able to track out this sweep if locked to a poor signal.

The present invention therefore provides a useful and efficient method for scanning for an obtaining data from data transport streams on data carriers over a range of known frequencies. By tuning to each known frequency on a step-by-step bases through each known frequency so the method ensures that each known frequency is checked, but the use of the sweep generator and the detection of the symbol rate ensures that the time taken at each frequency is significantly reduced before a decision is reached for each frequency as to whether or not there is a suitable carrier present.

## Claims

1. A method of identifying and locating digital data carriers received via a satellite data transmission system, said method comprising the steps of tuning a local oscillator incorporated in data receiving apparatus at the receiving location across a band of frequencies known to be received by the apparatus and **characterised in that** the local oscillator is tuned across said band of frequencies in steps and, at each step, an analysis is made as to whether a data carrier is identifiably present with a predefined symbol rate and, if so, a demodulator in the data receiving apparatus attempts to acquire the data transport stream which is associated with the located carrier.

2. A method according to claim 1 **characterised in that** the method utilises a symbol timing recovery loop operable in two modes, a first mode for the acquisition of the incoming symbol frequency and a second tracking mode once the incoming symbol frequency is identified to track the swept frequency as the timing error detector output is fed back into the loop.

3. A method according to claim 2 **characterised in that** a frequency sweep generator has 'three control parameters, the sweep rate, the lower sweep limit and upper sweep limit.

4. A method according to claim 1 **characterised in that** if at a particular step during the tuning, no data carrier is indicated, then the search process moves to the next frequency step and so on until the tuner has passed through the entire band of frequencies.

5. A method for installing data receiving apparatus in the form of a broadcast data receiver at a location remote from the location from which data is transmitted, said data transmitted at a range of known frequencies, and **characterised in that** said method comprises the steps of tuning a local oscillator provided in the data receiving apparatus to tune to each of the known frequencies, said tuning operation performed in steps, each step at a particular known frequency, and, at each step, an analysis is made at the data receiving apparatus as to whether a data carrier is identifiably present and, if so, whether a predefined data symbol rate is achieved and, if the predefined symbol rate is achieved at the identified data carrier a demodulator in the data receiving apparatus attempts to acquire the transport stream of data which is associated with that carrier.

6. A method according to claim 5 **characterised in that** a sweep generator is utilised at each frequency step.

7. A method according to claim 6 **characterised in that** the sweep generator has at least three parameters, the sweep rate, lower sweep limit and upper sweep limit and a status register.

8. A method according to claim 7 **characterised in that** the register for each step is controlled as follows:
the clock lower sweep and upper sweep limits, are initially set with narrow offsets
the sweep generator begins sweeping from the lower sweep limit, at a relatively slow sweep rate;
after a period of time that is sufficient for the loop to lock, the upper sweep limit is set to a wide offset, and the sweep is set to a fast rate;
the time taken for the clock sweep to reach the wide offset upper sweep limit is calculated;
the status register is continuously polled to see if the upper sweep limit has been reached for a maximum duration of the calculated sweep time;
if a signal is not present, then the noise in the loop will cause the upper sweep limit to be reached and/or exceeded, and the loop is declared not to be locked;
if the limit has not been reached, and the time to reach the upper sweep limit has expired, then the loop has locked.

9. A method according to claim 8 **characterised in that** the register control steps are followed at each frequency step.

10. A method as hereinbefore described with reference to the accompanying figure.
